**Europäisches Patentamt**

(19) **European Patent Office**

**Office européen des brevets**

(11) Veröffentlichungsnummer: **0 021 340**
**B1**

(12) # EUROPÄISCHE PATENTSCHRIFT

(45) Veröffentlichungstag der Patentschrift:
04.04.84

(51) Int. Cl.³: **G 01 R 19/04**

(21) Anmeldenummer: **80103398.6**

(22) Anmeldetag: **18.06.80**

(54) Vorrichtung zum Messen und Auswerten der Spitzenwerte eines pulsierenden Spannungssignales.

(30) Priorität: **23.06.79 DE 2925483**

(43) Veröffentlichungstag der Anmeldung:
**07.01.81 Patentblatt 81/1**

(45) Bekanntmachung des Hinweises auf die Patenterteilung:
**04.04.84 Patentblatt 84/14**

(84) Benannte Vertragsstaaten:
**AT CH DE FR GB LI**

(56) Entgegenhaltungen:
**DE - A - 2 444 655**
**DE - A - 2 713 191**
**DE - A - 2 719 591**
**DE - B - 1 250 921**
**DE - B - 2 362 917**

**Electronic Circuits, McGraw-Hill Electrical and**
**Electronic Engineering Series, Copyright 1958, 1964, S.**
**17, 18**

(73) Patentinhaber: **Kistler Instrumente AG,**
**Eulachstrasse 22, CH-8408 Winterthur (CH)**

(72) Erfinder: **Giorgetta, Mario, Rappstrasse 5,**
**CH-8408 Winterthur (CH)**

(74) Vertreter: **Pohlmann, Eckart, Dipl.-Phys. et al,**
**Patentanwälte POHLMANN & SCHMIDT**
**Siegfriedstrasse 8, D-8000 München 40 (DE)**

## Vorrichtung zum Messen und Auswerten der Spitzenwerte eines pulsierenden Spannungssignals

Die Erfindung betrifft eine Vorrichtung zum Messen und Auswerten der Spitzenwerte eines pulsierenden Spannungssignals.

Eine derartige Vorrichtung dient dazu, den Unterschied einer positiven oder negativen Spannungsspitze gegenüber dem vorangehenden Minimum zu messen, den Mittelwert dieser Unterschiede über eine bestimmte Anzahl von Signalzyklen zu bilden sowie die größte Änderung der Unterschiede untereinander in der bestimmten Anzahl von Signalzyklen zu ermitteln und das Ergebnis anzuzeigen.

Ein typischer Anwendungsfall für eine derartige Vorrichtung ist die Zylinderdrucküberwachung von Verbrennungsmotoren, bei der der Zylinderdruck von elektrischen Druckaufnehmern mit zugehöriger Elektronik gemessen wird. Das Ergebnis der Messung steht in Form einer druckproportionalen Strom- oder Spannungsgröße zur Verfügung, von der mit elektrischen Mitteln die einzelnen Spitzenwerte erfaßt werden. Aus einer bestimmten Anzahl von N Spitzenwerten wird dann der Mittelwert sowie der Unterschied vom kleinsten zum größten Spitzenwert bestimmt. Eine derartige Vorrichtung eignet sich aber auch ganz allgemein für die Auswertung von periodisch veränderlichen mechanischen Meßgrößen, die von Meßwertaufnehmern in elektrische Größen umgewandelt worden sind.

Der Spitzendruck von Verbrennungsmotoren kann im Laufe des Betriebs ansteigen, was zu einer Überbeanspruchung von verschiedenen Teilen der Motoren, insbesondere der Lager, und zum Bruch und zum Ausfall des Motors führen kann. Um das zu vermeiden, ist es insbesondere bei großen Dieselmotoren üblich, die Spitzendrücke von Zeit zu Zeit nachzumessen und bei Bedarf zu korrigieren. Eine Korrektur ist auch dann notwendig, wenn die Spitzendrücke zu niedrig sind, um dadurch den Brennstoffverbrauch zu senken.

Es sind tragbare mechanische Spitzendruckmeßvorrichtungen relativ kleiner Größen bekannt, die von Service-Monteuren vorwiegend bei Dieselmotoren angewandt werden.

Diese bekannten mechanischen Vorrichtungen sind im Prinzip aus einem Kolben oder einem Ventilteller aufgebaut, der in einem Zylinderteil beweglich ist. Der Zünddruck wird in den Zylinderteil geleitet, so daß der Kolben gegen eine Feder verschoben wird. Die Anzeige des Druckes erfolgt in verschiedener Weise. Bei einem Beispiel einer derartigen mechanischen Spitzendruckmeßvorrichtung verschiebt der Kolben einen Schreibstift auf einem Papier in vertikaler Richtung. Die Länge des Striches liefert das Maß für den Spitzendruck. Beim horizontalen Vorschub des Papiers wird das Druckzeitdiagramm des Zylinderdruckes aufgezeichnet. Bei einer weiteren bekannten Vorrichtung liegt an der Feder eine Vorspannung, die gerade so groß ist, daß der Spitzendruck nicht ausreicht, um den Ventilteller zu bewegen. Die Vorspannung der Feder ist das Maß für den Spitzendruck und wird an einer Skala abgelesen.

Alle diese mechanischen Vorrichtungen setzen voraus, daß am Motor ein Indizierstutzen vorhanden ist, der den Anschluß der Spitzenwertmeßvorrichtung am Motorenzylinder ermöglicht. Dieser Indizierstutzen ist die Ursache dafür, daß verschiedene Meßfehler auftreten. Er stellt einen Blindkanal dar, der an den Verbrennungsraum angeschlossen ist und durch den schnellen Druckanstieg im Verbrennungsraum zu Pfeifenschwingungen angeregt wird. Das führt zu einer Verfälschung des Druckverlaufs und einer Verfälschung der von der Spitzenwertmeßvorrichtung gemessenen Spitzenwerte. Indizierstutzen neigen außerdem dazu, zu verrußen, was gleichfalls zu Meßfehlern führt.

Es werden daher piezoelektrische Druckaufnehmer bevorzugt, die unmittelbar in den Brennraum bündig mit der Wandung eingebaut sind, wodurch eine Verfälschung der Meßergebnisse durch einen Blindkanal verhindert wird. Piezoelektrische Druckaufnehmer können sehr klein gebaut und als Zusatz in eine Zündkerze integriert werden. Dadurch ist es möglich, Druckverläufe in Ottomotoren ohne Induzierstutzen und -bohrung zu messen. Für die Zylinderdrucküberwachung mit piezoelektrischen Aufnehmern werden bisher zusätzliche Elektrometer- und Ladungsverstärker zur Umwandlung der vom Aufnehmer abgegebenen druckproportionalen Ladung in eine Meßspannung sowie ein Lichtstrahloszillograph benötigt, um das Druckdiagramm aufzuzeichnen. Der apparative Aufwand ist dabei so groß, daß die Messungen in der Regel nur von den Herstellern der Motoren durchgeführt werden können und für Servicearbeiten beim Benutzer des Motors nicht in Frage kommen.

Weiterhin haben piezoelektrische Meßketten, wie viele andere Meßketten die Eigenschaft, daß der Signalnullpunkt während der Messung wegdriftet. Es ist zwar möglich, bei stillstehendem Motor zu Beginn der Messung den Signalnullpunkt so abzugleichen, daß bei einem Druck gleich Null am Druckaufnehmer das angeschlossene Anzeige-, Meß- oder Registriergerät gleichfalls auf Null steht. Während des Meßbetriebes bei laufendem Motor verschiebt sich jedoch der Nullpunkt infolge einer Erwärmung des Aufnehmers im Motor sowie aufgrund der vom Ladungs- oder Elektrometerverstärker verursachten Störladung und schließlich durch die dynamische Übertragungscharakteristik des Meßsystems. Wenn nach abgeschlossener Messung der Druck am Aufnehmer wieder gleich Null ist, kann der Signalnullpunkt stark von seiner ursprünglichen Lage zu Beginn der Messung abweichen. Für ein fehlerfreies Meßresultat muß daher dieser Nullpunktdriftfehler

während der Messung dauernd berücksichtigt werden.

Zur Beurteilung des Verbrennungsablaufes in einem Motorenzylinder reicht es nicht aus, den besonders hohen Spitzendruck einer einzelnen Verbrennung zu kennen, wie er von einzelnen mechanischen Spitzenwertmeßvorrichtungen erfaßt wird. Vielmehr sollen der Mittelwert einer bestimmten Anzahl von Spitzendrücken sowie deren Streubreite ermittelt werden. Das erfordert eine Messung über eine längere Zeitperiode, während der der Driftfehler schon ein unzulässig hohes Ausmaß annehmen kann. Auf dem Prüfstand beim Hersteller des Motors ist es möglich, die wegdriftende Nullinie im Druckzeitdiagramm einzuzeichnen, die Spitzendrücke auszumessen und zu mitteln sowie die Spitzendruckstreuung auf graphisch-rechnerischem Weg zu bilden. Ein Service-Monteur, der derartige Messungen an Ort und Stelle beim Benutzer des Motors vornimmt, hat diese Möglichkeit jedoch nicht. Selbst wenn er die entsprechenden Geräte mit sich führen könnte, hätte er kaum Zeit und die Möglichkeit, die graphische Auswertung vorzunehmen.

Aus Electronic Circuits, McGraw-Hill Electrical and Electronic Engineering Series, Copyright 1958, 1964, Seiten 17, 18, ist eine Klemmschaltung bekannt, die durch Klemmen des anliegenden Signals auf die Nullinie automatisch einen eventuell durch eine Nullpunktdrift des Signals verursachten Fehler eliminiert.

Aus der DE-A-2 713 191 ist weiterhin eine Vorrichtung zum Messen und Auswerten der Spitzenwerte eines pulsierenden Spannungssignals bekannt, die eine Einrichtung enthält, die Spitzenwerte über eine bestimmte Anzahl von Signalzyklen jeweils mißt und auswertet. Bei dieser bekannten Vorrichtung wird abhängig vom Erreichen eines bestimmten Pegels auf der Flanke des Eingangssignals eine Umschaltung einer Verriegelungsstufe eingeleitet, die die Entladung eines Kondensators beeinflußt. Dabei schaltet die Verriegelungsstufe bei zwei verschiedenen Spannungen um. Diese bekannte Vorrichtung dient dazu, den Zeitpunkt der Spitzenwerte elektrischer Spannungen zu bestimmen.

Aus DE-B-2 362 917 ist es weiterhin bekannt, bei einem Spitzendetektor eine Spannung auf einen bestimmten Potentialwert zu klemmen, der allerdings nicht das Nullpotential ist.

Die der Erfindung zugrunde liegende Aufgabe besteht darin, eine Vorrichtung zum Messen und Auswerten der Spitzenwerte eines pulsierenden Spannungssignals zu schaffen, mit der eine sofortige Auswertung der vom Spannungssignal wiedergegebenen Meßergebnisse während einer Messung und eine laufende Überwachung der zugehörigen Meßgröße möglich sind.

Diese Aufgabe wird gemäß der Erfindung durch eine Vorrichtung zum Messen und Auswerten der Spitzenwerte eines pulsierenden Spannungssignals gelöst, die gekennzeichnet ist durch eine Einrichtung, deren Ausgangssignal am Eingang einer Meß- und Auswerteeinrichtung liegt und die das anliegende Spannungssignal mit dem Nullpotential vergleicht und zur Beseitigung des durch die Nullpunktdrift hervorgerufenen Fehlers diejenigen Signalanteile, die eine zur Polarität der Spitzenwerte des Spannungssignals entgegengesetzte Polarität aufweisen, bei ihrem Auftreten vom Spannungssignal abzieht und die ihr Ausgangssignal nach Erreichen jedes Spitzenwertes des Spannungssignals bei einem bestimmten Pegel der abfallenden Flanke des Spannungssignals auf das Nullpotential setzt und bis zum Anfang des Wiederanstieges des Signalpegels des Spannungssignals beim nächsten Impuls auf dem Nullpotential hält.

Im Gegensatz zu den bekannten Spitzenwertmeß- und -auswertevorrichtungen, die mit einem Elektrometer- oder Ladungsverstärker und einem Lichtstrahloszillographen zur Aufzeichnung des Druckdiagramms arbeiten, ist die erfindungsgemäße Vorrichtung zum Messen und Auswerten der Spitzenwerte eines pulsierenden Spannungssignals vorzugsweise so ausgebildet, daß jeweils über N Signalperioden die Spitzenwerte gemessen und ausgewertet werden, so daß eine nachträgliche Auswertung eines Oszillographendiagramms nicht mehr erforderlich ist. Die erfindungsgemäße Vorrichtung ist dabei so ausgebildet, daß der während der Messung auftretende Driftfehler laufend kompensiert wird, so daß die Meßergebnisse unverfälscht, d. h. driftfehlerkorrigiert geliefert werden und daß die Messung und Auswertung der Spitzenwerte praktisch augenblicklich durchgeführt werden.

Die Anwendung der erfindungsgemäßen Vorrichtung zum Messen und Auswerten der Spitzenwerte eines pulsierenden Spannungssignals ist nicht auf piezoelektrische Meßwertaufnehmer beschränkt, sie kann auch in Verbindung mit jedem anderen mechanisch-elektrisch arbeitenden Aufnehmersystem verwandt werden, bei dem Nullpunktdriftprobleme auftreten. Die Anwendung der erfindungsgemäßen Vorrichtung ist allgemein nicht auf Meßwertaufnehmer beschränkt, sie ist immer dann möglich, wenn nach dem nullpunktbezogenen Signalverlauf einer sich periodisch ändernden Meßspannung gefragt ist, während der Meßsignalnullpunkt variiert.

Bevorzugte Weiterbildungen der Erfindung sind Gegenstand der Patentansprüche 2 bis 12.

Im folgenden werden anhand der zugehörigen Zeichnung bevorzugte Ausführungsbeispiele der Erfindung näher beschrieben:

Fig. 1 zeigt ein typisches Diagramm des Druckverlaufes im Zylinder eines großen Dieselmotors, in Abhängigkeit der Zeit, bei einer Drehzahl von 96 Umdrehungen pro Minute. Der horizontale Zeitmaßstab beträgt 0,05 s pro Teilstrich, der vertikale Druckmaßstab beträgt 12,5 bar pro Teilstrich.

Fig. 2 zeigt das gleiche Diagramm wie Fig. 1, jedoch mit einem Zeitmaßstab von 5 s pro Teilstrich.

Fig. 3a zeigt schematisch die kapazitive Entkopplung eines piezoelektrisch erfaßten Signals vom Eingang einer Meß- und Auswerteeinrichtung, mittels welcher Nullpunktverschiebungen des pulsierenden Spannungssignals infolge Drifteinflusses vermindert werden.

Fig. 3b zeigt den wirklichen Druckverlauf in einem Dieselmotorenzylinder im Vergleich mit dem durch die kapazitive Entkopplung nach Fig. 3a verzerrten pulsierenden Spannungssignal.

Fig. 4a zeigt das Schema einer kapazitiven Entkopplung mit einer Gleichrichterdiode und einem Junctionfet.

Fig. 4b zeigt eine Sequenz von Druckzyklen in einem Dieselmotorenzylinder mit positiver sowie negativer Drift.

Fig. 4c zeigt den Einfluß der Schaltung 4a auf die pulsierenden Spannungssignale 4b, wenn der Junctionfet sperrt.

Fig. 4d zeigt den Einfluß der Schaltung 4a auf das pulsierende Spannungssignal 4b mit positiver Drift, wenn während der Signalabbauphasen der Junctionfet durch kurze Impulse mit Nullpotential an seinem Gateanschluß leitend gemacht wird.

Fig. 4e zeigt einen Ausschnitt aus Fig. 4d, vergrößert im Detail.

Fig. 5a zeigt ein erläuterndes Diagramm des Druckverlaufes im Zylinder eines Diselmotors sowie der Schaltfunktionen des Schmitt-Triggers.

Fig. 5b zeigt die Schaltung 4a mit automatischer Steuerung des Junctionfets.

Fig. 6 zeigt die Kapazitätsumladeschaltung mit Operationsverstärker.

Fig. 7 zeigt ein Gesamtschema der Einrichtung zur Beseitigung des durch die Nullpunktdrift hervorgerufenen Fehlers sowie der ihr nachgeschalteten Einrichtung zur Steuerung der Kurzschließung des Ausgangssignals in der vorangehenden die Nullpunktdrift beseitigenden Einrichtung, und zwar für ein Signal mit positiven Spitzenwerten.

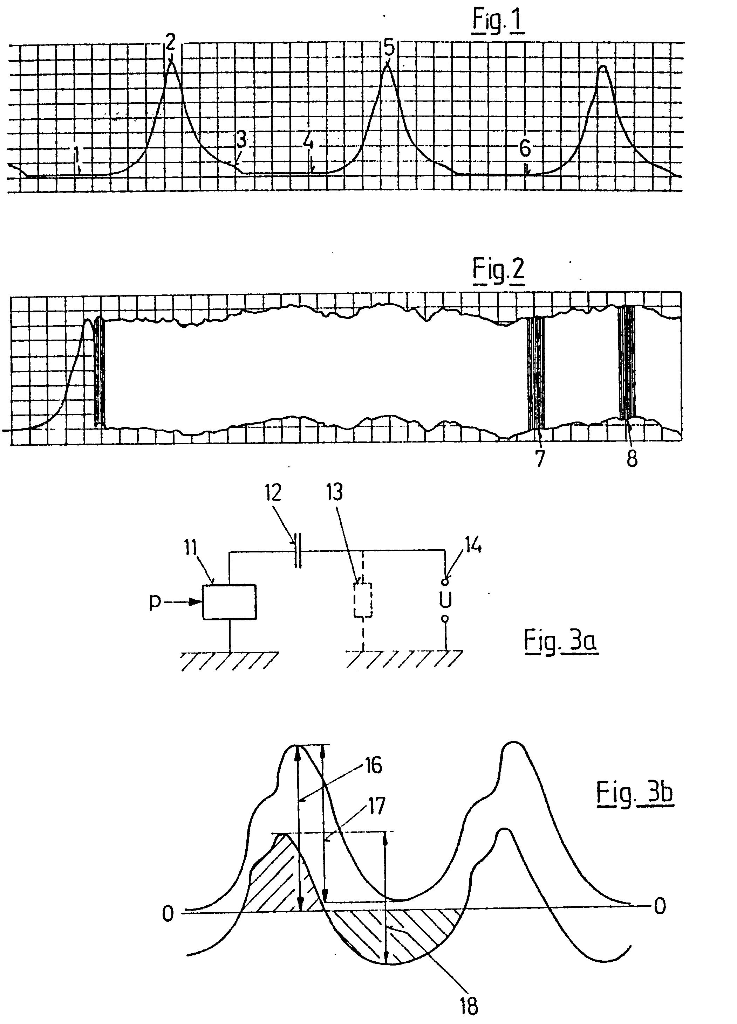

Fig. 1 zeigt die Aufzeichnung des Druckverlaufes in Abhängigkeit von der Zeit im Zylinder eines Zweitaktgroßdiesels bei einer Drehzahl von 96 Umdrehungen in der Minute. Dabei signalisiert Punkt 1 den tiefsten Zylinderdruck, 2 den Spitzendruck, 3 die Öffnung der Auslaß-Schlitze, 4 wiederum den tiefsten Zylinderdruck während der Gaswechselphase, 5 den Spitzendruck, 6 den tiefsten Zylinderdruck.

Interessant sind vor allem die Werte der Spitzendrücke der einzelnen Signalzyklen. Diese sind jedoch schwer aus dem Diagramm herauslesbar, da bezüglich des Nullpunktes auf dem Diagramm eine Unsicherheit besteht. Wohl ist es möglich, zu Beginn der Messung die Aufzeichnungslinie beispielsweise auf den unteren Skalenrand zu setzen, jedoch erfährt diese Null-Lage während der Anlaß- und Aufwärmphase des Motors eine Verschiebung. Bezieht man nun den Meßwertpegel auf die anfänglich eingestellte Null-Lage, so kann sich ein großer Meßfehler ergeben. Es ist jedoch bekannt, daß während dem Gaswechsel der Druck im Dieselzylinder dem Ladedruck von etwa 3 bar entspricht. Zu diesem Ladedruck ist der Differenzdruck vom tiefsten Zylinderdruck bis zum Spitzendruck, Punkt 1 bis 2 bzw. Punkt 4 bis 5 aus dem Diagramm Fig. 1 zu addieren. Aus Diagramm Fig. 1 ist ersichtlich, daß der tiefste Diagrammpunkt des Zylinderdruckes 6 tiefer als der entsprechende tiefste Punkt des Zylinderdruckes 4 liegt, obschon die Drücke die gleichen sind. Dies ist eine Folge negativer Nullpunktdrift. Bei Veränderung des Nullpunktes tritt eine entsprechende Lageveränderung der tiefsten Diagrammpunkte der Zylinderdrücke 1, 4, 6 ... auf, die aber stets 3 bar entsprechen.

In Diagramm Fig. 2 ist die Sequenz einer großen Anzahl Druckzyklen mit im Vergleich zu Diagramm Fig. 1 hundertmal kleinerem horizontalen Papiervorschub wiedergegeben. Der untere Rand des Meßsignalbandes zeigt den Verlauf des Gaswechselpunktes. Zwischen tiefstem Zylinderdruck 7 und 8 liegt eine Gruppe von 40 Signalzyklen. Während dieser Dauer verschiebt sich der Nullpunkt um etwa einen Teilstrich, was einem umgerechneten Druck von 12,5 bar entspricht. Bei Bezug der Spitzendruckwerte dieser 40 Zyklen auf den Pegel des tiefsten Zylinderdruckes 7 ergibt dies demzufolge einen Fehler von 12,5 bar bzw. einen mittleren Fehler von $\pm 6{,}25$ bar. Bezogen auf den Spitzenwert von etwa 100 bar ergibt dies den untragbaren Fehler von $+6{,}25\%$ resp. $-6{,}25\%$. Somit muß die Nullpunktverschiebung zur einwandfreien Messung der Spitzenwerte berücksichtigt werden.

Eine Nullpunktunstabilität, wie sie im Diagramm Fig. 2 der untere Rand des Bandes zeigt, ist eine Folge von zeitlich variierenden Wärmeeinwirkungen auf den Druckaufnehmer, bedingt durch unterschiedliche Gasströmungen während der Brennphase einzelner Zyklen. Durch das Vermeiden des Indizierstutzens und den in diesem Zusammenhang auftretenden Pfeifenschwingungen tritt zwar eine Fehlerquelle zurück, dafür tritt jedoch mit dem direkten Einbau des Aufnehmers in den Motorenzylinder und damit der unmittelbaren Berührung des Druckaufnehmers mit der Flammfront eine verstärkte Verschiebung des Signalnullpunktes auf. Eine solche Nullpunktverschiebung tritt nicht nur bei piezoelektrischen Aufnehmern, sondern auch bei Aufnehmern anderer Systeme in ähnlicher Weise auf. In der elektrischen Schalttechnik pflegt man Nullpunktunstabilitäten, wie in Fig. 2 gezeigt, durch kapazitive Signalentkopplung, wie in Fig. 3a gezeigt, zu eliminieren oder zumindest zu reduzieren.

Fig. 3a umfaßt den Druckaufnehmer 11, den Eingangskondensator 12, einen Ableitwiderstand 13 und den Signalausgang 14 für einen Nachfolgeverstärker. Oft übernimmt der Eingangswiderstand des Nachfolgeverstärkers die Funktion des Ableitwiderstandes 13, wodurch letzterer entfällt. Daher ist er in Fig. 3a gestrichelt eingezeichnet.

Schaltung 3a stellt ein Hochpaßfilter dar, das also hohe Frequenzen passieren läßt und tiefe Frequenzen sperrt. Ein Druckmeßsignal, wie es Fig. 1 darstellt, besitzt eine Zyklenfrequenz von mindestens 1 Hz, während in den Nullpunktschwankungen nach dem Diagramm Fig. 2, Frequenzanteile von etwa 1/100 Hz vorhanden sind. Durch den zu übertragenden kleinsten Meßfrequenzwert und den höchsten zu sperrenden Störsignalfrequenzwert ergibt sich die Grenzfrequenz des Filters nach Fig. 3a. Diese soll etwa zwischen diesen Frequenzwerten liegen, also bei 0,1 Hz. Der Abstand der Filtergrenzfrequenz zur Störsignal- sowie zur Meßfrequenz ist meistens aber zu gering, wodurch einerseits Nullpunktschwankungen zwar beträchtlich abgeschwächt werden, jedoch immer noch stören und andererseits das Meßsignal bereits verzerrt wird.

Das obere Diagramm in Fig. 3b zeigt den wirklichen Zylinderdruckverlauf, wobei 16 die Amplitude des Spitzendruckes und 17 die Druckdifferenz zwischen tiefstem Druck und Spitzendruck bezeichnet.

Das untere Diagramm zeigt das durch das Filter gemäß Fig. 3a verzerrte pulsierende Spannungssignal. Das Signal verteilt sich in der Weise um die Null-Linie, daß die über der Linie liegenden positiven Flächenanteile etwa den unter der Linie liegenden negativen Flächenanteilen entsprechen. Somit ist der Gaswechselpunkt bezüglich der Null-Linie nur solange stabil, wie Kurvenform und Amplitude des pulsierenden Spannungssignals konstant sind. Eine Veränderung derselben verändert auch die Flächenverhältnisse zur Null-Linie, und bewirkt demzufolge einen Flächenausgleich und dadurch eine kurvenform- und amplitudenabhängige Nullpunktdrift. Weiter ist die Druckdifferenz 18 gegenüber der Druckdifferenz 17 verkleinert, was eine Folge der Frequenzabhängigkeit der Amplitude des pulsierenden Spannungssignals in diesem Filterfrequenzbereich ist. Dieser Filter verfälscht aber nicht nur Amplitude und Nullpunkt des Signals, sondern auch den Zeitpunkt des Signalmaximums und -minimums. Dieser tritt zu früh ein, womit eine Phasenverschiebung nach links stattfindet; das pulsierende Spannungssignal eilt dem wirklichen Signalverlauf voraus. All diese Faktoren machen die besprochene Meß-Schaltung für das vorliegende Meßproblem ungeeignet.

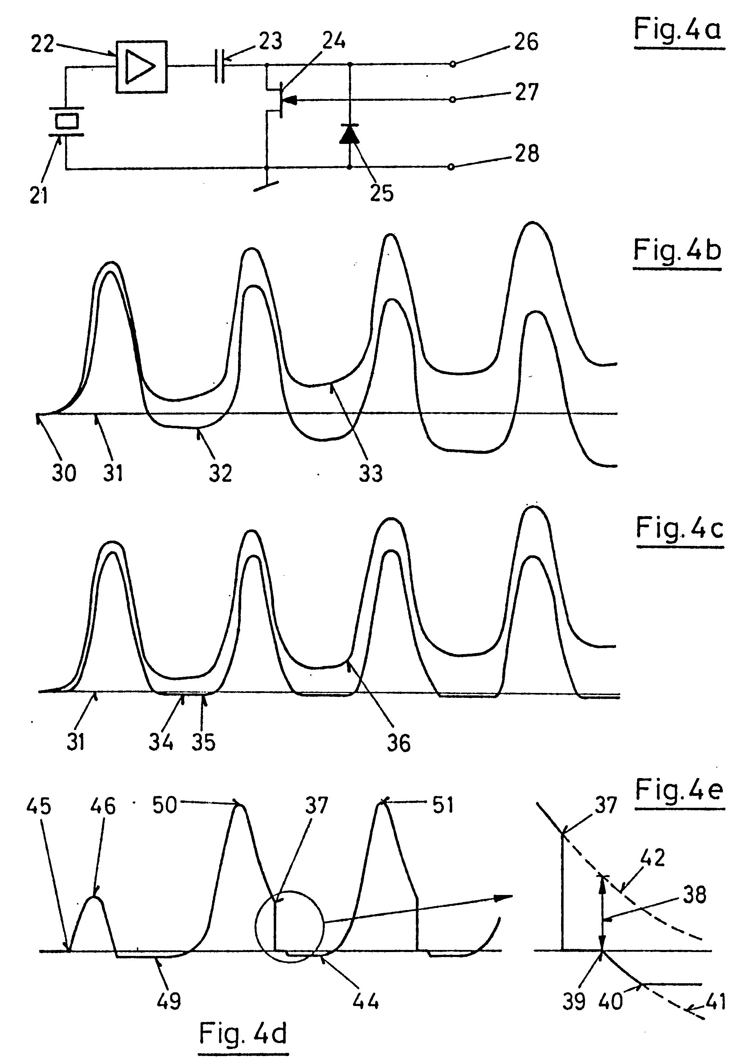

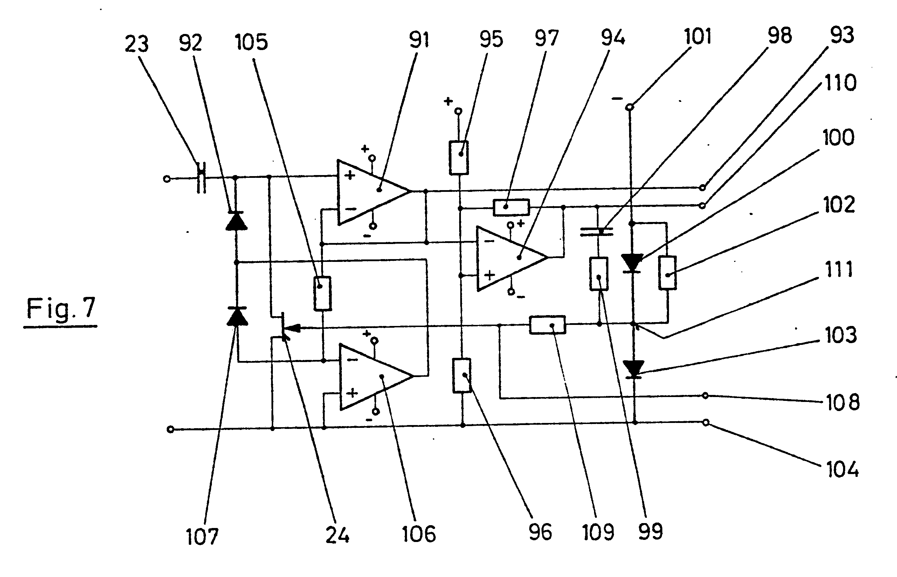

Eine verbesserte Schaltung zeigt Fig. 4a. 21 bezeichnet den Druckaufnehmer, 22 einen Impedanzwandler, 23 den Eingangskondensator, 24 einen Junctionfet N-Channel-Typ, 25 eine Diode, 26 den Signalausgang zum Nachfolgeverstärker, 27 den Steueranschluß für den Junctionfet 24 sowie 28 die Masse bzw. den Bezugspunkt des Meßsystems.

Liegt der Steueranschluß 27 auf Massepotential, so leitet der Junctionfet 24. Der Signalausgang 26 ist via Junctionfet 24 auf die Masse 28 kurzgeschlossen. Demzufolge kann keine Signalübertragung vom Druckaufnehmer 21 auf den Signalausgang 26 erfolgen. Um eine solche zu ermöglichen, muß der Steueranschluß 27 auf negatives Spannungspotential gelegt werden, womit der Junctionfet 24 sperrt. Jetzt können aber nur relativ zur Masse 28 positive pulsierende Spannungssignale an den Signalausgang 26 gelangen, negative Signale werden wiederum, diesmal über die parallel zum Junctionfet 24 liegende Diode 25 auf die Masse 28 kurzgeschlossen. Fig. 4b und 4c zeigen dieses Verhalten anhand der entsprechenden Diagramme. Fig. 4b zeigt den Signalverlauf des pulsierenden Spannungssignals am Ausgang des Impedanzwandlers 22 in Fig. 4a. Die Signale 32 und 33 beginnen jeweils mit dem tiefsten Zylinderdruck 30 auf der Null-Linie 31. Beide Signale sind miteinander identisch, bis auf die Nullpunktdrift, welche bei Signal 32 in negativer, bei Signal 33 in positiver Richtung verläuft. Gleichzeitig mit dem tiefsten Zylinderdruck 30 wird nun der Steueranschluß 27 in Fig. 4a negativ gesetzt, wodurch der Junctionfet 24 sperrt. Am Signalausgang 26 erscheint nun das Signal 33 unverändert, wie Signal 36 in Fig. 4c zeigt. Demgegenüber wird das negativ driftende Signal 32 durch die Diode 25 in der Weise korrigiert, wie dies aus dem Signal 34 in Fig. 4c hervorgeht. Infolge dieser Diode 25 kann die Spannung am Signalausgang 26 nur schwach negativ — etwa −0,7 V — werden. Dies entspricht der Schwellspannung der Diode 25. Da während besagter Kurzschlußphase durch die Diode 25 der Eingangskondensator 23 eine entsprechende Umladung über Diode 25 erfährt, verändert sich das Signal am Signalausgang 26 erst wieder, sobald es steigende Tendenz hat (nach Punkt 35 in Fig. 4c). Es bewegt sich dann von der Diodenschwellspannung weg, erreicht den Spitzenwert und sinkt während der Gaswechselphase wieder auf den Schwellwert. Punkt 35 entspricht dem tiefsten Zylinderdruck während der Gaswechselphase, also etwa 3 bar.

Die nachfolgende Auswertelektronik erfaßt den Spitzenwert und addiert die Diodenschwellspannung dazu. Mit dem Druck-Spannungsumsetzungsfaktor des Meßwertaufnehmers multipliziert ergibt dies unter Berücksichtigung des Ladedruckes den absoluten Spitzendruck. Die Diode hat also die Funktion eines Nullpunktkompensators, der den Signalnullpunkt beim Gaswechseldruck auf ein definiertes Spannungspotential stabilisiert. Dieses Verfahren arbeitet jedoch nur solange einwandfrei, wie eine negative Nullpunktdrift des pulsierenden Spannungssignals vorhanden ist, so wie dies Signal 32 in Fig. 4b zeigt. Bei positiver Drift, wie sie Signal 33 zeigt, oder wenn überhaupt keine Drift vorhanden ist, kann die Diode nie aktiv werden, da hierbei kein negativer Signalpegel entsteht. Positiv driftendes Signal wird mitsamt der Drift unverändert übertragen, wie dies Signal 36 in Fig. 4c zeigt. Hier kann nun eine künstlich erzeugte Kurzschlußphase im opportunen Zeitpunkt Abhilfe schaffen, womit durch die Zuführung einer negativen Ladung in den Eingangskondensator eine negative Drift entsteht. Der Kurzschluß wird mit dem Junctionfet 24 erzeugt, indem für die benötigte Dauer sein Steueranschluß 27 auf die Masse 28 gesetzt wird. Da der Signalverlauf des pulsierenden Spannungssignals grundsätzlich nur vom tiefsten Zylinderdruck bis zum Erreichen des Spitzenwertes interessiert (49 ... 50, 44 ... 51 usw. in Fig. 4d), kann die Kurzschlußphase zu einem beliebigen Zeitpunkt nach überschrittenem Spitzenwert bis zum Absinken des Signalpegels auf einen Wert, der noch um die Schwellspannung der Diode 25 über der Null-Linie resp. über dem Pegel von Masse 28 und mindestens um denselben Betrag über dem tiefsten Zylinderdruck liegt, eintreten.

Fig. 4d und 4e zeigen ein Signaldiagramm vom Signalausgang 26 in Fig. 4a. Fig. 4e zeigt einen Ausschnitt von 4d vergrößert im Detail. Punkt 37 signalisiert den Beginn der Kurzschlußphase, Punkt 39 das Ende der Kurzschlußphase. Diese ist also sehr kurz im Vergleich mit dem Signalzyklus. Durch das Kurzschließen des Signalausganges 26 in Fig. 4a auf die Masse 28 zu Beginn der Kurzschlußphase 37 (Fig. 4d und 4e) wird dem Eingangskondensator 23 soviel negative Ladung zugeführt, daß das Signal am Signalausgang 26 beim Ende der Kurzschlußphase 39 (Fig. 4e) eine negative Pegelverschiebung um den Kompensationsbetrag 38 aufweist. Nun sinkt das Signal aber noch bis auf den tiefsten Zylinderdruck. Den Signalverlauf ohne Kurzschlußphase zeigt die gestrichelte Linie 42. Den durch den Kompensationsbetrag 38 verschobenen Signalverlauf zeigt Linie 41. Somit sinkt der Signalpegel, unabhängig von der Driftrichtung des Signalnullpunktes, bis zum negativen Diodenschwellspannungspegel 40, wodurch mit dem bereits erwähnten Nullpunktkompensationseffekt der Diode 25 die Stabilisierung des Signalnullpunktes gewährleistet ist.

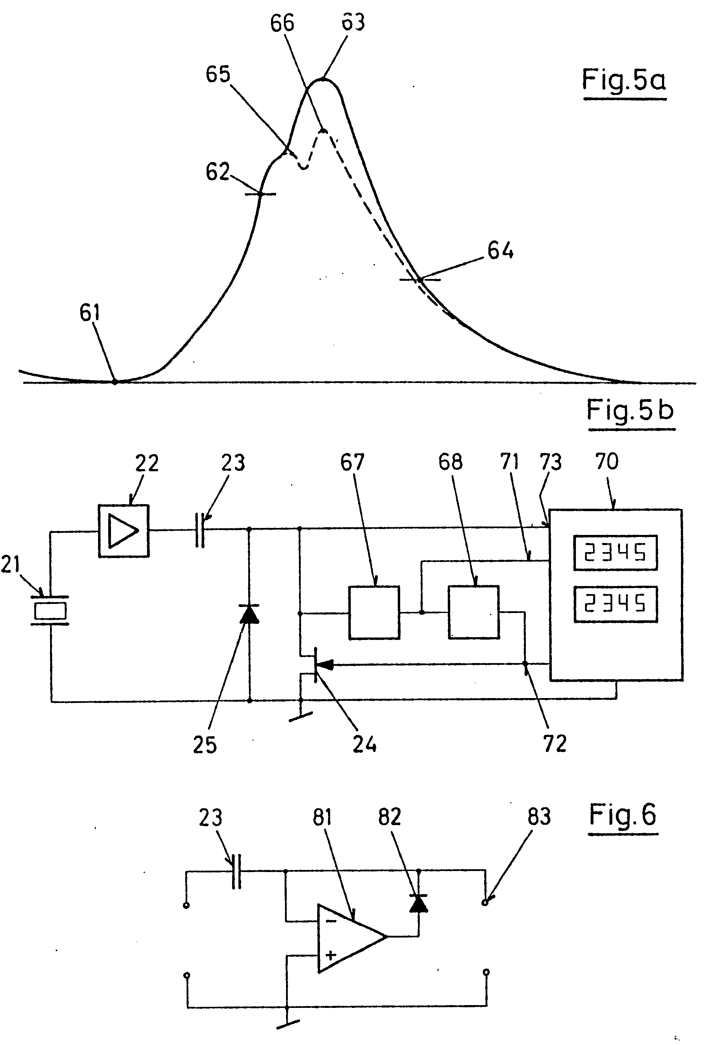

Das zur Verwirklichung der Kurzschlußphase erforderliche Nullungssignal wird durch die Signalzyklen selbst ausgelöst. Fig. 5a und b zeigen, wie dies erfolgen kann. Der linke Teil von Fig. 5b mit Druckaufnehmer 21, Impedanzwandler 22, Eingangskondensator 23, Junctionfet 24 und Diode 25 entspricht dem Schaltkreis gemäß Fig. 4a. Zusätzlich ist dieser Schaltkreis durch einen Schmitt-Trigger 67 oder eine ähnliche Schaltung sowie durch einen monostabilen Multivibrator 68 oder eine ähnliche Schaltung und ferner ein Steuer-, Auswerte- und Anzeigegerät 70 erweitert. Das Steuer-, Auswerte- und Anzeigegerät 70 hält die Steuerleitung des Junctionfets 24, also dessen Gateanschluß, vor Beginn der Messung auf Nullpotential und unterbindet damit die Übertragung des Signals zum Signaleingang 73 des Auswertegerätes, das sich selbst im Nullzustand befindet. Sobald die Messung beginnen soll, wird mit dem Startbefehl über die Steuerleitung 72 der Gateanschluß des Junctionfets 24 auf negatives Potential gesetzt, womit der Junctionfet 24 sperrt. Die Sperrwiderstände von Diode 25 und Junctionfet 24 sowie die Eingangswiderstände des Schmitt-Triggers 67 und des Auswertegerätes sind sehr hoch. Demzufolge ist die Übertragungszeitkonstante der Schaltung als Produkt aus den Werten des Isolationswiderstandes und des Eingangskondensators 23 ebenfalls sehr hoch, was eine entsprechend tiefe Grenzfrequenz ergibt. Hiermit treten keine in der in Fig. 3b dargestellten Weise entstehende Signalverzerrungen auf. Beim Erreichen eines gewissen Druckes resp. Spannungspegels am Signaleingang 73 des Auswertegerätes bzw. am Eingang des Schmitt-Triggers 67, schaltet letzterer von Null auf 1, d. h. das Ausgangspotential desselben springt von Null oder negativem Speisespannungspotential auf positives Speisespannungspotential. Dieser Einschaltpegel ist, bezogen auf den Signalnullpunkt 61 im Diagramm Fig. 5a, konstant und mit Punkt 62 gekennzeichnet. Nachdem das pulsierende Spannungssignal den Spitzenwert 63 überschritten hat, durchläuft es in der nachfolgenden abfallenden Phase den Ausschaltpegel 64, bei dem der Schmitt-Trigger von 1 zurück auf Null schaltet. Auch dieser Ausschaltpegel 64 ist, bezogen auf den Signalnullpunkt 61, konstant und somit vom pulsierenden Spannungssignal nicht beeinflußbar. Der Rückschalttransient regt nun den monostabilen Multivibrator 68 an. An seinem Ausgang entsteht dadurch ein konstanter Impuls mit einer Pulsbreite entsprechend dem Zeitabschnitt vom Beginn der Kurzschlußphase 37 bis zum Ende der Kurzschlußphase 39 gemäß Fig. 4e. Während dieser aktiven Zeit beträgt die Spannung am Multivibratorausgang 68 Null, während sie sich im unaktiven Zustand, also in der übrigen Zeit, auf negativem Spannungspotential befindet. Durch die Verbindung des Multivibratorausganges mit der Steuerleitung 72 und somit mit dem Gateanschluß des Junctionfets 24 wird die bereits erwähnte Kurzschlußphase realisiert, infolge derer der Signalnullpunktpegel für den folgenden Signalzyklus stabilisiert wird. Die Kurzschlußphase findet also stets zu jenem Zeitpunkt statt, bei dem der Signalpegel, vom Einschaltpegel 62 in Fig. 5a aus abfallend, den Ausschaltpegel 64 durchläuft.

Das Steuer-, Auswerte- und Anzeigegerät 70 erfaßt und verarbeitet eine bestimmte Anzahl von Spitzenwerten der Signalzyklen, um nachfolgend durch Nullpotential an der Steuerleitung 72 jede weitere Übermittlung von Signalen zu sperren. Dazu muß das Steuer-, Auswerte- und Anzeigegerät 70 die verarbeiteten Signalzyklen zählen und mit dem Sollwert vergleichen. Zur Signalverarbeitung addiert es die einzelnen Spitzenwerte der Signalzyklen zueinander und bildet den Mittelwert, danebst ermittelt es die Differenz des größten zum kleinsten Spitzenwert und zeigt abschließend Mittelwert und Differenz an. Der Meßbeginn wird durch die manuelle Bedienung einer Start-Taste ausgelöst. Die Signalverarbeitung setzt nun aber nicht sofort ein. Da die Start-Taste zu einem beliebigen Zeitpunkt gedrückt wird, kann sich der Signalpegel in diesem Moment auf einem beliebigen Wert innerhalb seines Meßbereiches befinden und eine beliebige Bewegungsrichtung aufweisen. Im gesperrten Zustand der Schaltung, also bei Nullpotential an der Steuerleitung 72, wird am Eingangskondensator 23 soviel Ladung zu- und abgeführt, daß die Summe der Ausgangsspannung des Impedanzwandlers 22 mit dem Eingangskondensatorspannungsabfall am Eingang 73 des Auswertegerätes stets Null ergibt. Somit wird im Augenblick des Startbefehls und dem damit erfolgten Unterbleiben der Umladung des Eingangskondensators 23 der Nullpegel des Eingangssignals des Auswertegerätes beim momentanen Pegel des Ausgangssignals des Impedanzwandlers 22 festgesetzt und befindet sich somit meistens am falschen Ort. Dabei können sich grundsätzlich zwei verschiedene Situationen ergeben:

a)  Der Startbefehl erfolgt während der abfallenden Phase des pulsierenden Spannungssignals. Wie bereits bekannt, wird nun der Nullpunkt am Signaleingang 73 des Auswertegerätes solange stabilisiert, bis das Signal wieder steigende Tendenz aufweist. Dies ist nun erst mit dem nächstfolgenden Signalzyklus der Fall, womit jetzt für diesen der Nullpunkt stimmt.

b)  Der Startbefehl erfolgt während der ansteigenden Phase des pulsierenden Spannungssignals, wie dies in Fig. 4d dargestellt im Startzeitpunkt 45 der Fall ist. Nun erscheint am Signaleingang 73 des Auswertegerätes das Signal mit einer Amplitude vom Startzeitpunkt 45 bis zum Spitzenwert 46 und weist somit meistens einen falschen Wert auf. Der Spitzenwert 50 des nächstfolgenden Meßzyklus jedoch stimmt.

Situation b definiert nun allgemein die Bedingung, daß das Steuer-, Auswerte- und Anzeigegerät 70 stets erst mit dem zweiten eintreffenden Meßzyklensignal die Signalverarbeitung starten darf. Als Meßzyklenzählsignal verwendet das Auswertegerät den Rückschalttransienten des Schmitt-Triggers 67. So kann es also vorkommen, daß der erste übertragene Spitzenwert 46 so klein ist, daß er vom Schmitt-Trigger 67 als Störsignal aufgefaßt wird und somit keinen Rückschalttransienten erzeugt. Der zweite, in seinem Pegel nun stimmende Spitzenwert 50 erzeugt den ersten Rückschalttransienten und wird somit vom Steuer-, Auswerte- und Anzeigegerät 70 noch nicht verarbeitet. Dies geschieht erst mit dem dritten übertragenen Signalzyklus mit seinem Spitzenwert 51. Das Meßzyklenzählsignal resp. der Rückschalttransient wird in Fig. 5b durch die Leitung 71 übertragen.

Grundsätzlich bestehen zur Verwirklichung der Steuerung des Einsatzzeitpunktes für die Kurzschlußphase noch weitere Schaltungsmöglichkeiten. Die Hauptbedingung dabei bleibt, daß dieser Zeitpunkt während der Signalabbauphase nach überschrittenem Spitzenwert eintreten muß. So kann beispielsweise der Einsatzzeitpunkt durch Differenzierung des pulsierenden Spannungssignals bestimmt werden. Hier wird stets, wenn ein Signal mit fallender Tendenz im Meßkanal vorhanden ist, der monostabile Multivibrator angeregt und somit die Kurzschlußphase eingeleitet. Dies kann jedoch vermehrt zu Fehlmessungen führen, wie dies im folgenden anhand des gestrichelten Verlaufes von Diagramm Fig. 5a erläutert wird.

Ein im Leerlauf betriebener Dieselmotor überschreitet oft den Kompressionsdruck 65 mit einem ersten Druckmaximum. Der Verbrennungsdruck 66 ergibt nun ein zweites Maximum. Bei Anregung des monostabilen Multivibrators 68 als Folge jedes negativen Meßsignaldifferentialkoeffizienten ist dies hier bereits nach erreichtem Kompressionsdruck 65 der Fall. Mit der Schmitt-Trigger-Schaltung, bei der zwischen den zum Schaltungsnullpunkt konstanten Ein- bzw. Ausschaltpegeln 62 und 64 eine definierte Hysterese liegt, sind solche Fehlerfunktionen auf ein Minimum reduziert. Eine weitere Schwierigkeit bezüglich zeitlicher Differenzierung des pulsierenden Spannungssignals bietet ein sehr langsam sich veränderndes Signal, wie dies beispielsweise bei der Drucküberwachung in der Kunststoffverarbeitung der Fall ist. Hier bildet sich ein Differentialsignal sehr kleinen Wertes. Außerdem führen auch Störsignale, wie Brumm- und Schaltstöße, vermehrt zur Anregung des Multivibrators im falschen Zeitpunkt und somit zu Fehlmessungen. Die Problematik liegt also ganz allgemein in der richtigen Klassifizierung des Meßzyklus aus dem pulsierenden Spannungssignal. Diese Klassifizierung ist mit der geschilderten Meßmethode durch den Schmitt-Trigger 67 mit Hysterese im vollen Umfang gewährleistet.

Fig. 6 zeigt eine schaltungstechnische Verbesserung der Schaltung 5b. Diese besteht darin, daß anstelle der Diode 25 in Fig. 5b die Kombination der Diode 82 mit dem Operationsverstärker 81 tritt. Vom Eingangskondensator 23 auf den Signalausgang 83 übertragenes negatives Potential ist auch am invertierenden Operationsverstärkereingang wirksam. Der Operationsverstärker wird demzufolge an seinem Ausgang positiv ausgesteuert. Dadurch fließt ein positiver Ausgleichsladestrom via Diode 82 in den Eingangskondensator 23, womit der invertierende Verstärkereingang resp. der Signalausgang 83 auf Null bleibt. Im Gegensatz dazu wird ein vom Kondensator übertragenes positives Potential nicht beeinflußt. Obwohl der Operationsverstärker 81 dadurch negativ ausgesteuert wird, kann kein negativer Ausgleichsladestrom fließen, da ein solcher von Diode 82 gesperrt wird. Bei leitender Diode 82 liegt der Ausgang des Operationsverstärkers 81 auf Schwellspannungspotential derselben. In der Praxis beträgt diese Spannung von ungefähr 0,7 V bei einer inneren Verstärkung des Verstärkers 81 von $10^5$

auf seinen Eingang bezogen etwa 7 µV; der Eingang bleibt also praktisch auf Null. Damit ist die Eingangsimpedanz des Operationsverstärkers 81 für Signale positiven Pegels unendlich hochohmig, für solche negativen Pegels jedoch unendlich niederohmig, also Null. Den Bezugspunkt für diese Pegel bildet der nicht invertierende Eingang von Operationsverstärker 81, der mit Masse verbunden ist. In dieser aus der bekannten Präzisionsgleichrichterschaltung hervorgehenden Anordnung ist also die Diodenschwellspannung eliminiert. Ihre Anwendung im Schema Fig. 5b ergibt folgende Vorteile.

1. Die Schwellspannung von Diode 25, die zur Signalauswertung mitberücksichtigt werden muß, kann individuell verschieden sein, was zu Meßunsicherheiten führt. Durch ihre wertmäßige Reduktion um den Faktor der inneren Verstärkung von Operationsverstärker 81 kann diese Schwellspannung samt ihren Streuungen vernachlässigt werden. Das gleiche gilt für den Temperatureinfluß auf die Schwellspannung.
2. Die Umladung des Eingangskondensators 23 im Zeitabschnitt vom Beginn der Kurzschlußphase 37 bis zum Ende der Kurzschlußphase 39 (Fig. 4d) ist mit dem Fußpunkt des Junctionfets 24 auf die Masse bezogen. Die Stabilisierung des Signalnullpunktes erfolgt jedoch auf einem Pegel, der um die Diodenschwellspannung von Diode 25 vom Massepotential abweicht. Damit wird die Stabilisierung nur dann erreicht, wenn nach Ende der Kurzschlußphase 39 der Pegel des pulsierenden Spannungssignals noch mindestens um den Diodenschwellspannungsbetrag sinkt. Durch die Reduktion der Schwellspannung auf einen vernachlässigbaren Betrag und das damit verbundene Zusammenfallen des Massepotentials mit dem Stabilisierpegel für den Signalnullpunkt wird diese Bedingung hinfällig.
3. Der statische sowie der dynamische Innenwiderstand der Diode werden ebenfalls um den Faktor der inneren Verstärkung von Operationsverstärker 81 verkleinert, was sämtliche dadurch hervorgerufene Einflüsse entsprechend reduziert. Vor allem wird dadurch ein fehlerfreier Meßbetrieb selbst bei hoher Zyklenfrequenz gewährleistet, wo eine schnelle Umladung des Eingangskondensators 23 wichtig ist.

Der Schaltungsteil nach Fig. 5b ist mit dem Eingangskondensator 23, dem Junctionfet 24, der Diode 25, dem Schmitt-Trigger 67 und dem monostabilen Multivibrator 68 nur grob schematisch dargestellt. Fig. 7 zeigt eine detaillierte Schaltung dieser Komponenten mit Ersatz der Diode 25 durch eine gemäß der nach Fig. 6 besprochenen Kombination arbeitende Schaltung.

Nummer 23 bezeichnet wiederum den Eingangskondensator, der Signale positiven und negativen Pegels auf die weitere Schaltung überträgt. Diese werden auf den nicht invertierenden Eingang des Operationsverstärkers 91 geleitet. Diode 92 sowie Junctionfet 24 sperren hierbei. Operationsverstärker 91 hat die Funktion eines Impedanzwandlers mit hohem Eingangswiderstand und überträgt das Signal weiter zum Signalausgang 93. Dieser ist mit dem Eingang der Auswerte- und Anzeigeeinheit verbunden. Mit dem Einsatz von Operationsverstärker 91 wird bezweckt, daß die Übertragungszeitkonstante für Signale durch den Eingangskondensator 23 extrem hoch liegt, was eine Verfälschung des Signalverlaufs ausschließt. Der Ausgang von Operationsverstärker 91 führt auch auf den invertierenden Eingang des als Schmitt-Trigger geschalteten Operationsverstärkers 94, dessen nicht invertierender Eingang an einem Spannungsteiler aus den Widerständen 95 und 96 liegt. Der nicht invertierende Eingang des Operationsverstärkers 94 ist somit positiv vorgespannt, wodurch die Ausgangsspannung von Operationsverstärker 94 solange in der positiven Begrenzung weilt, wie der Pegel an seinem invertierenden Eingang negativer als diese Vorspannung ist. Die Vorspannung wird, nebst den Widerständen 95 und 96, auch vom Rückkopplungswiderstand 97 mitbestimmt. Dieser bewirkt eine zusätzliche positive Verschiebung der Vorspannung, solange die Spannung am Verstärkerausgang in der positiven Begrenzung liegt. Sobald durch das pulsierende Spannungssignal die Spannung am invertierenden Eingang von Operationsverstärker 94 über den Vorspannungspegel am nicht invertierenden Eingang steigt, springt die Verstärkerausgangsspannung von der positiven in die negative Begrenzung. Hiermit verschiebt der Rückkopplungswiderstand 97 die positive Vorspannung am nicht invertierenden Eingang des Operationsverstärkers 94 in negativer Richtung und unterstützt damit die auslösende Ursache. Nun muß das Signal am invertierenden Verstärkereingang erst wieder um diesen verschobenen Wert negativer werden, bevor die Ausgangsspannung von Operationsverstärker 94 auf den ursprünglichen Wert zurückkehrt. Durch diese Hysterese ist die Schaltung vergleichbar mit einem Kippschalter. Infolge des Spannungssprunges von der positiven in die negative Begrenzung der Ausgangsspannung von Operationsverstärker 94, fließt ein negativer Ladestrom über Kondensator 98 und Widerstand 99 via Diode 100 auf die negative Speisespannung 101. Der Gateanschluß von Junctionfet 24 wird über Widerstand 109 und Widerstand 102 auf negativem Speisespannungspotential festgehalten, wodurch der Junctionfet 24 sperrt. Durch den negativen Ladestrom wird die negative Gatespannung um die Schwellspannung von Diode 100 erhöht; der Junctionfet 24 bleibt gesperrt. Wenn nach überschrittenem Spitzendruck das pulsierende Spannungssignal mit dem Erreichen des entsprechenden Schaltpunktes eine sprunghafte

Änderung der Ausgangsspannung von Operationsverstärker 94 von der negativen zurück in die positive Begrenzung bewirkt, fließt ein positiver Ladestrom über Kondensator 98 und Widerstand 99 via Diode 103 auf die Masse 104. Die Gatespannung von Junctionfet 24 steigt demzufolge auf den positiven Schwellspannungswert von Diode 103. Dadurch wird der Junctionfet 24 leitend und setzt den nicht invertierenden Eingang von Operationsverstärker 91 auf Null. Solange der positive Ladestrom durch Diode 103 fließt, nämlich bis sich der Kondensator 98 auf die positive Begrenzungsspannung von Operationsverstärker 94 abzüglich der Schwellspannung von Diode 103 aufgeladen hat, bleibt die Gatespannung auf dem Schwellspannungswert von Diode 103. Danach sinkt sie, infolge des Ladestroms von der negativen Speisespannung durch den Widerstand 102 und 99 in den Kondensator 98, Richtung negative Speisespannung und sperrt dadurch den Junctionfet 24. Dazu ist ein definierter negativer Spannungspegel notwendig, der je nach verwendetem Junctionfet-Typ in der Größenordnung von einigen Volt liegt. Das Erreichen dieser Spannung beschließt mit dem dadurch erfolgenden Sperren des Junctionfets 24 die Kurzschlußphase des Fets. Nach diesem Zeitpunkt hat das vom Eingangskondensator 23 übertragene pulsierende Spannungssignal noch immer fallende Tendenz. Demzufolge sollte am nicht invertierenden Eingang des Operationsverstärkers 91 der Spannungspegel unter Null sinken. Dies ist jedoch nicht möglich, da negatives Spannungspotential über Operationsverstärker 91 und Widerstand 105 auf den invertierenden Eingang von Operationsverstärker 106 wirkt. Dieser Verstärker bildet mit der Diode 92 eine Schaltung zur Eliminierung der Diodenschwellspannung nach dem Prinzip von Fig. 6 und kompensiert somit ein negatives Potential am nicht invertierenden Eingang von Operationsverstärker 91 mittels eines positiven Ladestroms durch den Eingangskondensator 23. Während dieser Phase steigt die Ausgangsspannung von Operationsverstärker 106 nur auf den Schwellspannungswert von Diode 92, während sich der nicht invertierende Eingang von Operationsverstärker 91 und folglich auch der Signalausgang 93 auf Nullpotential befindet. Die Diode 107 tritt in Funktion, wenn über Eingangskondensator 23 ein Signal positiven Potentials übertragen wird. Dieses Signal wirkt über Operationsverstärker 91 und Widerstand 105 auf den invertierenden Eingang von Operationsverstärker 106. Dadurch würde der Ausgang von Operationsverstärker 106 ohne Diode 107 in die negative Begrenzung ausgesteuert. Für diesen unnötigen Spannungshub benötigt der Operationsverstärker 106 in der Praxis eine gewisse Zeit, die wiederum aufgebracht werden muß, wenn bei neuerlichem negativen Signalpegel die Ausgangsspannung von Operationsverstärker 106 von der negativen Begrenzung auf positives Potential steigen soll. Dadurch kann eine störende Verzögerung der Kompensation von negativem Signalpegel am nicht invertierenden Eingang von Operationsverstärker 91 auftreten. Mit Diode 107 nun sinkt der Ausgangspegel von Operationsverstärker 106 bei negativer Aussteuerung nur um das Schwellspannungspotential von Diode 107 unter den Nullpunkt. Der maximale Hub der Ausgangsspannung von Operationsverstärker 106 geht somit aus der Summe der Schwellspannungen der Dioden 92 und 107 hervor und bewirkt infolge seines geringen Wertes eine schnellere Ansprechzeit dieser Schaltung als ohne Diode 107.

Steueranschluß 108 ist mit dem Steuer-, Auswerte- und Anzeigegerät 70 verbunden. Solange die Einheit diese Leitung auf Nullpotential hält, ist die Übertragung des pulsierenden Spannungssignals unterbunden. In Fig. 7 bildet Operationsverstärker 94 zusammen mit den Widerständen 95 und 96 sowie dem Rückkopplungswiderstand 97 die als Schmitt-Trigger 67 bezeichnete Einheit in Fig. 5b. Der Kondensator 98 hat in Verbindung mit den Widerständen 99, 102 und 109 sowie den Dioden 100 und 103 die Funktion der als monostabiler Multivibrator 68 bezeichneten Einheit in Fig. 5b. Genau genommen handelt es sich hierbei lediglich um ein Zeitverzögerungsglied mit der geforderten Arbeitsweise.

Am Triggerausgang 110 wird das Schmitt-Trigger-Ausgangssignal für die Bildung der Summe der übertragenen Signalzyklen durch das Steuer-, Auswerte- und Anzeigegerät 70 während der Messung ausgekoppelt. Dieser Anschluß entspricht der Leitung 71 in Fig. 5b.

Bei zusammenfassender Betrachtung des Schaltkreises gemäß Fig. 7 kann festgestellt werden, daß dieser die ihm gestellten Aufgaben mit einer Mindestzahl von Komponenten löst. Es besteht die Möglichkeit, andere Schaltkreise mit ähnlichen oder gleichen Funktionen zu erstellen. Die beschriebene Schaltung jedoch zeichnet sich durch besondere Einfachheit und Zuverlässigkeit aus.

Die bisher beschriebene Einrichtung dient dazu, den Pegelunterschied einer Wechselspannung von einem Minimum bis zum nächstfolgenden positiven Maximum zu bestimmen. Die Einrichtung kann aber ebenso dazu dienen, den Unterschied von einem Minimum bis zum nächstfolgenden negativen Maximum zu bestimmen. Für eine Messung in dieser Weise müssen die Dioden 25, 82, 92, 107, 100 und 103 umgekehrt gepolt sein. Anstelle eines Junctionfet 24 N-Channel-Typs muß ein P-Channel-Typ verwendet werden. Der Spannungsteiler mit Widerstand 95 und 96 muß an der negativen Speisespannung und Diode 100 mit Widerstand 102 an der positiven Speisespannung liegen.

Die Schaltung kann in ihrer Arbeitsweise als selbstregelnder Spannungskompensator aufgefaßt werden, wobei die Kompensation, in durch die Meßsignalzyklen gesteuerte endliche Zeitintervalle unterteilt, nur im dafür günstigsten Zeitabschnitt wirksam ist. Der hiermit noch auftretende Nullpunktdrifteinfluß beschränkt sich auf die Dauer von Beginn der ansteigenden Amplitude des pulsierenden Spannungssignals bis zum Erreichen von deren Spitzenwert. Im Fall von Spitzendruckmessung an Verbrennungsmotoren ist die resultierende Verfälschung des Signals vernachlässigbar klein.

**Patentansprüche**

1. Vorrichtung zum Messen und Auswerten der Spitzenwerte eines pulsierenden Spannungssignals, gekennzeichnet durch eine Einrichtung (24, 25, 67, 68; 24, 81, 82, 67, 68; 24, 91, 92, 94 bis 99, 102, 105 bis 107, 109), deren Ausgangssignal am Eingang einer Meß- und Auswerteeinrichtung (70) liegt und die das anliegende Spannungssignal mit dem Nullpotential vergleicht und zur Beseitigung des durch die Nullpunktdrift hervorgerufenen Fehlers diejenigen Signalanteile, die eine zur Polarität der Spitzenwerte des Spannungssignals entgegengesetzte Polarität aufweisen, bei ihrem Auftreten vom Spannungssignal abzieht und die ihr Ausgangssignal nach Erreichen jedes Spitzenwertes des Spannungssignals bei einem bestimmten Pegel der abfallenden Flanke des Spannungssignals auf das Nullpotential setzt und bis zum Anfang des Wiederanstieges des Signalpegels des Spannungssignals beim nächsten Impuls auf dem Nullpotential hält.

2. Vorrichtung nach Anspruch 1, dadurch gekennzeichnet, daß ein Eingangskondensator (23) zum Einkoppeln des Spannungssignals vorgesehen ist, und daß die Einrichtung zur Beseitigung des durch die Nullpunktdrift hervorgerufenen Fehlers aus einer Einrichtung (25; 81, 82) zum Umladen des Eingangskondensators (23), die zwischen den durch den Eingangskondensator (23) kapazitiv entkoppelten Eingang für das Spannungssignal und Nullpotential geschaltet ist, einer Schaltung (67) mit zwei definierten Ausgangssignalpegeln, an der das eingekoppelte Signal liegt und die bei Überschreiten eines bestimmten Pegels des anliegenden Signals ihre Ausgangssignalspannung von dem einen definierten Pegel auf den zweiten definierten Pegel ändert und bei Unterschreiten eines zweiten bestimmten Pegels des anliegenden Signals auf den ersten definierten Ausgangssignalpegel zurückschaltet, einer monostabilen Multivibratorschaltung (68), an der das Ausgangssignal der Schaltung (67) mit zwei definierten Ausgangssignalpegeln liegt und die durch das Rückschalten der Ausgangssignalspannung der Schaltung (67) mit zwei definierten Ausgangssignalpegeln angeregt wird, und einem elektrisch steuerbaren Schalter (24) aufgebaut ist, der zwischen dem durch den Eingangskondensator (23) kapazitiv entkoppelten Eingang für das Spannungssignal und Nullpotential liegt und von der monostabilen Multivibratorschaltung (68) angesteuert wird.

3. Vorrichtung nach Anspruch 2, dadurch gekennzeichnet, daß die Meß- und Auswerteeinrichtung (70) so ausgebildet ist, daß sie nach dem Einschalten die Messung und Auswertung erst mit dem Signalzyklus beginnt, der bewirkt, daß die Schaltung (67) mit zwei definierten Ausgangssignalpegeln zum zweiten Mal zurückschaltet.

4. Vorrichtung nach Anspruch 1, 2 oder 3, dadurch gekennzeichnet, daß die Meß- und Auswerteeinrichtung (70) so ausgebildet ist, daß sie die gemessenen Spitzenwerte arithmetisch mittelt und den Unterschied zwischen dem kleinsten und dem größten Spitzenwert ermittelt.

5. Vorrichtung nach Anspruch 2, dadurch gekennzeichnet, daß die Einrichtung zum Umladen des Eingangskondensators (23) eine Diode (25) ist.

6. Vorrichtung nach Anspruch 2, dadurch gekennzeichnet, daß die Einrichtung zum Umladen des Eingangskondensators (23) aus einem Operationsverstärker (81) mit einer zwischen seinen Ausgang und seinen invertierenden Eingang geschalteten Diode (82) besteht, wobei der invertierende Eingang des Operationsverstärkers (81) am durch den Eingangskondensator (23) kapazitiv entkoppelten Eingang für das Spannungssignal und sein nicht invertierender Eingang an Nullpotential liegt.

7. Vorrichtung nach Anspruch 2, dadurch gekennzeichnet, daß die Einrichtung zum Umladen des Eingangskondensators (23) aus einem als Impedanzwandler geschalteten Operationsverstärker (91), der zwischen den Eingangskondensator (23) und den Ausgang (93) der Einrichtung zum Umladen des Eingangskondensators (23) geschaltet ist, aus einem Operationsverstärker (106), zwei Dioden (92, 107) und einem Widerstand (105) besteht, wobei die beiden Dioden (92, 107) entgegengesetzt gepolt am Ausgang des Operationsverstärkers (106) liegen, eine der beiden Dioden (107) am invertierenden Eingang des Operationsverstärkers (106) und die andere Diode (92) am Eingang des Impedanzwandlers liegt und der invertierende Eingang des Operationsverstärkers (106) über den Widerstand (105) mit dem Ausgang des Impedanzwandlers verbunden ist, während der nicht invertierende Eingang dieses Operationsverstärkers (106) an Nullpotential liegt.

8. Vorrichtung nach einem oder mehreren der Ansprüche 2 bis 7, dadurch gekennzeichnet, daß die Schaltung (67) mit zwei definierten Ausgangssignalpegeln ein Hystereseverhalten mit einer Breite der Hystereseschleife zeigt, die größer als die Störsignale ist, die dem Spannungssignal überlagert sind.

9. Vorrichtung nach Anspruch 8, dadurch gekennzeichnet, daß die Schaltung (67) mit zwei definierten Ausgangssignalpegeln aus einem Operationsverstärker (94) besteht, dessen invertierender Eingang den Eingang der Schaltung (67) mit zwei definierten Ausgangssignalpegeln bildet und dessen nicht invertierender Eingang mit einem positiven oder negativen Spannungspegel vorgespannt ist, wobei dieser Pegel durch einen an positiver bzw. negativer Spannung liegenden Spannungsteiler aus zwei Widerständen (95, 96) und einen die Breite der Hystereseschleife bestimmenden Rückkopplungswiderstand (97) gebildet ist, der zwischen dem Ausgang und dem nicht invertierenden Eingang des Operationsverstärkers (94) liegt.

10. Vorrichtung nach einem oder mehreren der Ansprüche 2 bis 8, dadurch gekennzeichnet, daß die Schaltung (67) mit zwei definierten Ausgangssignalpegeln eine Schmitt-Trigger-Schaltung ist.

11. Vorrichtung nach einem oder mehreren der Ansprüche 2 bis 10, dadurch gekennzeichnet, daß die monostabile Multivibratorschaltung (68) aus einem Kondensator (98), drei Widerständen (99, 102, 109) und zwei Dioden (100, 103) besteht, wobei die Serienschaltung aus dem Kondensator (98) und einem der Widerstände (99) den Eingang der Multivibratorschaltung (68) mit einem Knotenpunkt (111) verbindet, der den Verbindungspunkt der zwei in Serie geschalteten Dioden (100, 103) bildet, die bezüglich der negativen bzw. positiven Speisespannung (101) in Sperrichtung geschaltet sind und zwischen dieser Speisespannung (101) und Nullpotential (104) liegen, und wobei der Knotenpunkt (111) über einen Widerstand (102) mit der negativen bzw. positiven Speisespannung (101) und über einen anderen Widerstand (109) mit dem Ausgang (108) der Multivibratorschaltung (68) verbunden ist.

12. Vorrichtung nach Anspruch 2, dadurch gekennzeichnet, daß der elektrisch steuerbare Schalter (24) ein n- oder p-Kanal Junctionfet ist.

**Claims**

1. Apparatus for measuring and evaluating the peak values of a pulsatory voltage signal, characterised by means (24, 25, 67, 68; 24, 81, 82, 67, 68; 24, 91, 92, 94 to 99, 102, 105 to 107, 109), the output signal of which is applied to the input of a measuring and evaluating means (70), and which compares the voltage signal applied with zero potential and for removing the error caused by zero-point drift deducts from the voltage signal those portions of the signal which have a polarity opposed to the polarity of the peak values of the voltage signal as they occur, and which at a predetermined level of the decaying edge of the voltage signal after each peak value has been reached, sets its output signal to zero potential and keeps it at zero potential until the beginning of the reascent of the signal level of the voltage signal at the time of the next pulse.

2. Apparatus according to claim 1, characterised in that an input capacitor (23) is provided for coupling in the voltage signal and that the means for removing the error caused by the zero-point drift comprises means (25; 81, 82) for charging the input capacitor (23) in the opposite direction, said means being connected between the input for the voltage signal decoupled capacitively by said input capacito and zero potential, a circuit (67) with two predetermined output signal levels, to which the coupled-in signal is applied and which on exceeding a predetermined level of the signal applied changes its output signal voltage from one predetermined level to the second predetermined level and on falling below a second predetermined level of the signal applied, switches back to the first predetermined output signal level, a monostable multivibrator circuit (68) to which the output signal of the circuit (67) with two predetermined output signal levels is applied and which is excited by switching back the output signal voltage of the circuit (67) with two predetermined output signal levels, an an electrically controllable switch (24) which is connected between the input for the voltage signal decoupled capacitively by the input capacitor (23) and zero potential and activated by the monostable multivibrator circuit (68).

3. Apparatus according to claim 2, characterised in that the measuring and evaluation means (70) is constructed so that, when it is turned on, it begins the measurement and evaluation only at the signal cycle which causes the circuit (67) with two predetermined output signal levels to switch back for the second time.

4. Apparatus according to claim 1, 2 or 3, characterised in that the measuring and evaluation means (70) is constructed so that it ascertains the mean value of the measured peak values arithmetically and ascertains the difference between the minimum and maximum peak values.

5. Apparatus according to claim 2, characterised in that the means for charging the input capacitor (23) in the opposite direction is a diode (25).

6. Apparatus according to claim 2, characterised in that the means for charging the input capacitor (23) in the opposite direction comprises an operational amplifier (81) with a diode (82) connected between the output and the inverting input of said operational amplifier, wherein the inverting input of the operational amplifier (81) is at the input for the voltage signal decoupled capacitively by the input capacitor (23) and the non-inverting input at zero potential.

7. Apparatus according to claim 2, characterised in that the means for charging the input capacitor (23) in the opposite direction comprises an operational amplifier (91) connected as an impedance transformer between the input capacitor (23) and the output (93) of the means for charging the input capacitor (23) in the opposite direction, an operational amplifier (106), two diodes (92, 107) and a resistor (105), wherein the two diodes (92, 107) oppositely polarized arc connected to the output of the operational amplifier (106), one of the two diodes (107) being connected to the inverting input of the operational amplifier (106) and the other diode (92) to the input of the impedance transformer, said inverting input of the operational amplifier (106) is connected via the resistor (105) to the output of the impedance transformer, whereas the non-inverting input of said operational amplifier (106) is at zero potential.

8. Apparatus according to one or more of claims 2 to 7, characterised in that the circuit (67) with two predetermined output signal levels has a hysteresis characteristic defined by a width of the hysteresis loop, which is greater than the disturbance signals superimposed on the voltage signal.

9. Apparatus according to claim 8, characterised in that the circuit (67) with two predetermined output signal levels comprises an operational amplifier (94), inverting input of which forms the input of the circuit (67) with two predetermined output signal levels, and the non-inverting input of which is biased with a positive or negative voltage level, the said voltage level being provided by a voltage divider consisting of two resistors (95, 96), to which a positive or negative voltage is applied and a feedback resistor (97) determining the width of the hysteresis loop, the feedback resistor (97) being connected between the output and the non-inverting input of the operational amplifier (94).

10. Apparatus according to any one or more of claims 2 to 8, characterised in that the circuit (67) with two predetermined output signal levels is a Schmitt trigger circuit.

11. Apparatus according to any one or more of claims 2 to 10, characterised in that the monostable multivibrator circuit (68) comprises a capacitor (98), three resistors (99, 102, 109) and two diodes (100, 103), wherein the series connection of the capacitor (98) and one of said resistors (99) connects the input of the multivibrator circuit (68) to a junction (111) forming the connecting point of the two diodes (100, 103) connected in series, said diodes with regard to the negative or positive supply voltage (101) are connected in the blocking direction and between the supply voltage (101) and zero potential (104), said junction (111) is connected via a resistor (102) to the negative or positive supply voltage (101) and via another resistor (109) to the output (108) of the multivibrator circuit (68).

12. Apparatus according to claim 2, characterised in that the electrically controllable switch (24) is an n- or p-channel junction FET.

**Revendications**

1. Appareil pour la mesure et l'craluation des valeurs de pointe d'un signal de tension pulsant, caractérisé par un dispositif (24, 25, 67, 68; 24, 81, 82, 67, 68; 24, 91, 92, 94 à 99, 102, 105 à 107, 109) dont le signal de sortie se trouve à l'entrée d'un dispositif de mesure et d'evaluation (70), qui compare le signal de tension présent au potentiel zéro et qui, aux fins d'élimination de l'erreur résultant de la dérive du zéro, déduit du signal de tension, à leur apparition, celles des fractions du signal dont la polarité est inverse à celle des valeurs de pointe du signal de tension, et qui met son signal de sortie, après obtention de chaque valeur de pointe du signal de tension pour un niveau déterminé du flanc chutant du signal de tension, au potentiel zéro et l'y maintient, lors de l'impulsion suivante, jusqu'au début de la nouvelle montée du niveau du signal de tension.

2. Appareil selon la revendication 1, caractérisé en ce qu'un condensateur d'entrée (23) est prévu pour le couplage du signal de tension, et que le dispositif aux fins d'élimination de l'erreur résultant de la dérive du zéro est constitué d'un dispositif (25; 81, 82) destiné à l'inversion de charge du condensateur d'entrée (23), cet appareillage étant branché entre l'entrée, découplée capacitivement par le condensateur d'entrée (23), pour le signal de tension et le potentiel zéro, d'un montage (67) ayant deux niveaux de signal de sortie définis, auquel se trouve le signal couplé et qui, lors du dépassement d'un niveau défini du signal présent, modifie sa tension du signal de sortie de l'un niveau défini sur le deuxième niveau défini, et qui, étant inférieur à un deuxième niveau défini du signal présent recommute sur le premier niveau du signal défini, d'un montage en multivibrateur monostable (68), auquel se trouve le signal de sortie du montage (67) ayant deux niveaux du signal de sortie définis et qui est excité par la rétrogradation de la tension du signal de sortie du montage (67) ayant deux niveaux du signal définis, et d'un interrupteur (24) à commande électrique branché entre l'entrée pour le signal de tension, découplée capacitivement par le condensateur d'entrée (23) et le potentiel zéro et qui est piloté par le montage (68) en multivibrateur monostable.

3. Appareil selon la revendication 2, caractérisé en ce que le dispositif de mesure et d'evaluation (70) est formé de sorte que, étant enclenché, la mesure et le traitement ne débutent qu'en présence du cycle de signaux qui fait que le montage (67) ayant deux niveaux du signal de sortie définis rétrograde pour la deuxième fois.

4. Appareil selon la revendication 1, 2 ou 3, caractérisé en ce que le dispositif de mesure et d'evaluation (70) est formé de sorte qu'il donne la moyenne arithmétique des valeurs de pointe mesurées et calcule la différence entre la valeur de pointe minimale et la valeur de pointe maximale.

5. Appareil selon la revendication 2, caractérisé en ce que le dispositif aux fins d'inversion de charge du condensateur d'entrée (23) est une diode (25).

6. Appareil selon la revendication 2, caractérisé en ce que le dispositif destiné à l'inversion de charge du condensateur d'entrée (23) se compose d'un amplificateur opérationnel (81) avec une diode (82) branchée entre sa sortie et son entrée invertissante, l'entrée invertissante de l'amplificateur opérationnel (81) se trouvant à l'entrée pour le signal de tension, découplée capacitivement par le condensateur d'entrée (23), et son entrée non invertissante au potentiel zéro.

7. Appareil selon la revendication 2, caractérisé en ce que le dispositif destiné à l'inversion de charge du condensateur d'entrée (23) se compose d'un amplificateur opérationnel (91) monté en transformateur d'impédance, cet amplificateur étant branché entre le condensateur d'entrée (23) et la sortie (93) du dispositif destiné à l'inversion de charge du condensateur d'entrée (23), d'un amplificateur opérationnel (106), de deux diodes (92, 107) et d'une résistance (105), les deux diodes se trouvant en polarité contraire à la sortie de l'amplificateur opérationnel (106), l'une des deux diodes (107) à l'entrée invertissante de l'amplificateur opérationnel (106) et l'autre diode (92) à l'entrée du transformateur d'impédance et l'entrée invertissante de l'amplificateur opérationnel (106) étant reliée à la sortie du transformateur d'impédance par le biais de la résistance (105), alors que l'entrée non invertissante de cet amplificateur opérationnel (106) se trouve au potentiel zéro.

8. Appareil selon une ou plusieurs des revendications 2 à 7, caractérisé en ce que le montage (67) ayant deux niveaux du signal de sortie définis présente un comportement hystérétique dont la largeur du cycle d'hystérésis est supérieure aux signaux parasites superposés au signal de tension.

9. Appareil selon la revendication 8, caractérisé en ce que le montage (67) ayant deux niveaux du signal de sortie définis se compose d'un amplificateur opérationnel (94) dont l'entrée invertissante forme l'entrée du montage (67) ayant deux niveaux du signal de sortie et dont l'entrée non invertissante est pourvue d'un niveau de tension polarisé positivement ou négativement, ce niveau étant formé par un diviseur de tension mis à tension positive, resp. négative, composé de deux résistances (95, 96) et d'une résistance de contre-réaction (97) qui détermine l'amplitude du cycle hystérétique, qui se trouve entre la sortie et l'entrée non invertissante de l'amplificateur opérationnel (94).

10. Appareil selon l'une ou plusieurs des revendications 2 à 8, caractérisé en ce que le montage (67) ayant deux niveaux du signal de sortie est un montage en trigger de Schmitt.

11. Appareil selon l'une ou plusieurs des revendications 2 à 10, caractérisé en ce que le montage en multivibrateur monostable (68) se compose d'un condensateur (98), de trois résistances (99, 102, 109) et de deux diodes (100, 103), le branchement en série du condensateur (98) et de l'une des résistances (99) reliant l'entrée du montage en multivibrateur (68) à un point nodal (111) qui forme le point de connexion des deux diodes (100, 103) branchées en série, qui sont branchées, quant à la tension d'alimentation négative, resp. positive (101) en sens de non-conduction et se trouvent entre cette tension d'alimentation (101) et le potentiel zéro (104), ce point de connexion (111) étant relié par le biais d'une résistance (102) à la tension négative ou positive (101) et par le biais d'une autre résistance (109) à la sortie (108) du montage en multivibrateur (68).

12. Appareil selon la revendication 2, caractérisé en que le commuateur à commande électrique (24) est un jonctionfet à n- ou p-canaux.

Fig. 1

Fig. 2

Fig. 3a

Fig. 3b

Fig. 4a

Fig. 4b

Fig. 4c

Fig. 4e

Fig. 4d

Fig. 7

Fig.5a

Fig.5b

Fig.6